(19) Europäisches Patentamt
European Patent Office
Office européen des brevets

(11) EP 1 043 837 A1

# (12) DEMANDE DE BREVET EUROPEEN

(43) Date de publication:
**11.10.2000 Bulletin 2000/41**

(51) Int. Cl.[7]: **H03J 3/08**, H03J 7/04, H04L 27/233

(21) Numéro de dépôt: **00201145.0**

(22) Date de dépôt: **30.03.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **07.04.1999 FR 9904345**

(71) Demandeur:
**Koninklijke Philips Electronics N.V.
5621 BA Eindhoven (NL)**

(72) Inventeurs:
- **Chouly, Antoine, Société Civile S.P.I.D. 75008 Paris (FR)**
- **Brajal, Américo, Société Civile S.P.I.D. 75008 Paris (FR)**

(74) Mandataire: **Chaffraix, Jean
Société Civile S.P.I.D.
156, Boulevard Haussmann
75008 Paris (FR)**

## (54) Correction du décalage de fréquence dans un système de transmission par paquets

(57) L'invention concerne un système de transmission par paquets de terminaux interactifs (2) vers une station de tête (1). Le problème qui se pose est le suivant: pour des raisons de coût, les terminaux sont équipés d'oscillateurs locaux peu précis de telle sorte qu'ils utilisent des porteuses présentant des erreurs en fréquence relativement importantes par rapport à la valeur de référence théoriquement utilisée (Fp).

L'invention permet d'améliorer la réception des signaux qui présentent un décalage en fréquence (Δf) relativement important, en particulier elle permet de résoudre l'interférence inter-symboles en sortie du filtre passe bande de réception (22).

Pour cela, l'invention consiste à estimer l'erreur en fréquence pour le signal reçu (bloc 27), et à recentrer en fréquence le signal reçu et le filtre de réception (bloc 30). Cette opération est répétée jusqu'à ce que l'erreur en fréquence (Δf(i)) estimé soit inférieure à un seuil fixé (S1, S2).

Application: systèmes de transmission interactifs par satellite ou par câble.

14
13
16
18
20
22
25
26
32
F'
Fp - F'
O.L.
12
40
27
30
28
29
FIG.2
10

EP 1 043 837 A1

## Description

L'invention concerne un système de transmission par paquets, d'au moins un terminal vers une station de tête, ladite station de tête comportant des moyens de réception pour recevoir un signal transmis par un terminal et un estimateur de fréquence pour estimer à partir du signal reçu une erreur en fréquence relative audit terminal.

L'invention concerne également un récepteur et un procédé de correction en fréquence à la réception, pour système de transmission par paquets.

L'invention a d'importantes applications, notamment dans le domaine des transmissions par satellite ou par câble avec voies de retour, dans lesquelles une pluralité de terminaux transmettent des données vers une station de tête selon un mécanisme de répartition des ressources en temps et en fréquence. De telles transmissions des terminaux vers la station de tête sont appelées transmissions montantes.

Ce type de terminaux est destiné au grand public. Il est donc important de réduire au maximum leur prix de revient. Pour cela, il est notamment avantageux d'utiliser des oscillateurs locaux de faible prix pour générer les fréquences porteuses à utiliser pour les transmissions montantes. Ces oscillateurs locaux sont imprécis: typiquement on utilise des oscillateurs dont la précision varie entre 1 ppm (de l'anglais "part per million") et 10 ppm. L'erreur qui en résulte sur la fréquence porteuse générée est proportionnelle à la fréquence porteuse. Cette erreur est donc d'autant plus gênante que les fréquences utilisées sont élevées. A titre d'exemple, dans les systèmes de transmission par satellite qui utilisent la bande de fréquences 20Ghz - 30Ghz pour les transmissions montantes, l'écart en fréquence obtenu pour un oscillateur local ayant une précision de 1 ppm peut atteindre ±30kHz (c'est-à-dire que pour une fréquence symbole B de 100kHz, l'écart de fréquence normalisé par rapport à la fréquence symbole est de ±30%).

Le brevet américain 5,794,119 délivré le 11 août 1998 décrit une méthode de contrôle en fréquence qui permet de réduire l'incertitude sur les fréquences porteuses utilisées pour des transmissions montantes.

Cette méthode consiste à utiliser l'une des deux techniques suivantes, ou les deux à la fois:

- la première technique consiste à émettre à partir de la station de tête un signal de référence ayant une grande précision en fréquence, à estimer l'erreur en fréquence au niveau du terminal, et à utiliser cette estimation pour corriger la fréquence porteuse à l'émission de façon à compenser la dérive de l'oscillateur local du terminal.
- la seconde technique consiste à estimer au niveau de la station de tête l'erreur en fréquence faite par chaque terminal, et à transmettre cette estimation au terminal correspondant pour qu'il corrige la fréquence porteuse à l'émission.

La première technique présente notamment l'inconvénient d'augmenter la complexité des terminaux, ce qui va à l'encontre de l'objectif précité de réduction du coût des terminaux. La seconde méthode est efficace mais, prise isolément, elle est insuffisante lorsque les fréquences porteuses considérées sont élevées. En effet, il reste toujours une dérive résiduelle de l'oscillateur local, et lorsque les fréquences en jeu sont élevées cette dérive entraîne un décalage relativement important.

L'invention a notamment pour but de proposer un système pour améliorer la réception de signaux qui présentent un décalage en fréquence relativement important. Pour cela, un système de transmission selon l'invention et tel que décrit dans le paragraphe introductif est caractérisé en ce que lesdits moyens de réception comportent un filtre passe bande et des moyens de centrage pour centrer en fréquence l'un par rapport à l'autre, le filtre passe bande et le signal stocké, en fonction de ladite erreur en fréquence.

De même un récepteur selon l'invention est caractérisé en ce que lesdits moyens de réception comportent un filtre passe bande et des moyens de centrage pour centrer en fréquence, l'un part rapport à l'autre, le filtre passe bande et le signal stocké, en fonction de ladite erreur en fréquence.

Et un procédé selon l'invention de correction en fréquence à la réception est caractérisé en ce qu'il comporte:

- une étape de filtrage passe bande, pour filtrer le signal reçu au moyen d'un filtre passe bande,
- une étape de centrage pour centrer en fréquence, l'un par rapport à l'autre, le filtre passe bande et le signal reçu, en fonction de ladite erreur en fréquence.

Lorsque les terminaux sont équipés d'oscillateurs locaux imprécis, la fréquence porteuse qui est utilisée par un terminal pour transmettre un signal présente, par rapport la fréquence porteuse qui aurait dû être utilisée en théorie, une erreur qui peut être relativement importante. L'invention permet d'éviter que le filtre passe bande de la station de tête ne coupe une partie du signal utile, à cause de cette erreur en fréquence. Les interférences inter-symboles en sortie du filtre passe bande sont ainsi réduites, ce qui permet d'améliorer les performances du système.

Lesdits moyens de centrage sont avantageusement constitués par des moyens de décalage en fréquence du signal reçu. Dans un autre mode de réalisation plus complexe, ce sont les coefficients du filtre passe bande qui sont modifiés pour le centrer en fréquence sur le signal reçu.

L'estimation de l'erreur en fréquence est effectuée en utilisant un algorithme d'estimation connu.

Un algorithme d'estimation est notamment caractérisé par se plage d'acquisition, c'est-à-dire par les écarts en fréquence qu'il est capable d'estimer. Les algorithmes qui sont actuellement couramment utilisés sont au mieux capables de récupérer des erreurs en fréquence normalisées par rapport à la fréquence symbole $\tilde{\Delta}f = \Delta f/B$ de ±50% (où $\Delta f$ est l'erreur en fréquence et B est la fréquence symbole).

Dans un autre mode de réalisation de l'invention, la station de tête comporte, en amont du filtre passe bande, un filtre à large bande et des moyens de traitement pour transposer un signal capturé par le filtre à large bande dans la bande dudit filtre passe bande. Ce mode de réalisation permet de gérer des erreurs en fréquence qui se situent hors de la plage d'acquisition de l'estimateur utilisé.

L'invention sera mieux comprise et d'autres détails apparaîtront dans la description qui va suivre en regard des dessins annexés qui sont donnés à titre d'exemples non limitatifs et dans lesquels:

- la figure 1 représente un exemple de système de transmission selon l'invention,
- la figure 2 représente schématiquement un récepteur selon l'invention,
- la figure 3 représente un premier mode de réalisation du récepteur de la figure 2,
- les figures 4 et 5 représentent deux variantes d'un mode de réalisation préférentiel du récepteur de la figure 2,

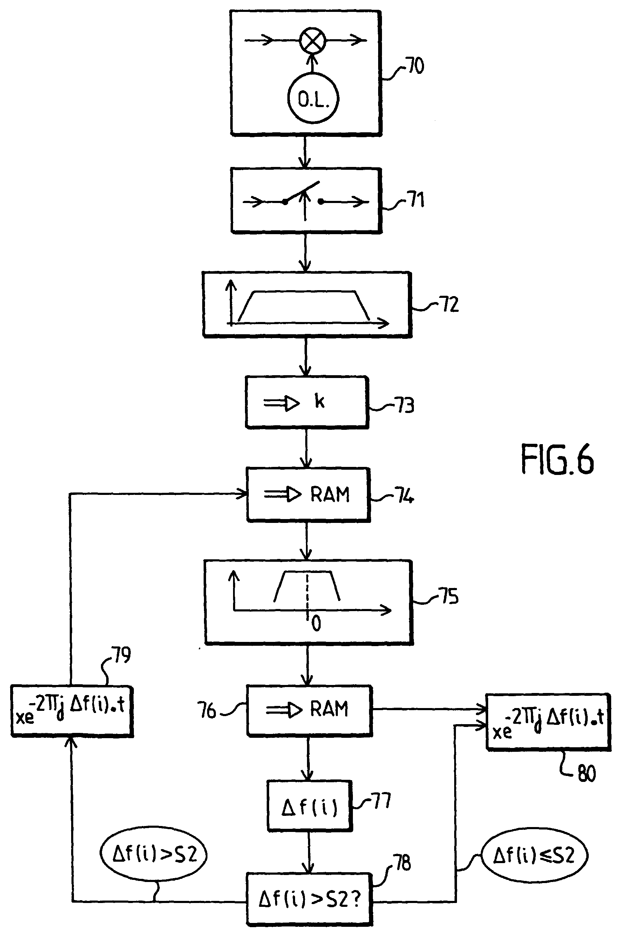

- la figure 6 représente un exemple préférentiel de procédé selon l'invention.

Les éléments communs aux différentes figures portent les mêmes références.

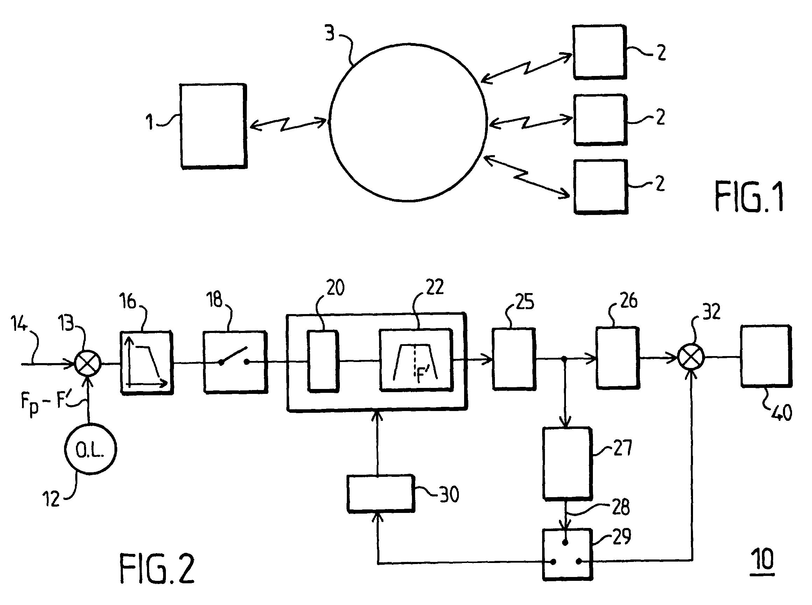

Sur la figure 1 on a représenté à titre d'exemple un système de transmission selon l'invention. Ce système comporte une station de tête 1 et une pluralité de terminaux interactifs 2 susceptibles de transmettre des données vers la station de tête en accédant à un média de transmission 3. De telles transmissions des terminaux vers la station de tête sont qualifiées de transmissions montantes. Dans les transmissions montantes, la station de tête 1 a la fonction d'un récepteur. L'accès des terminaux au média de transmission se fait par exemple en utilisant un mécanisme d'accès multiple à répartition en fréquence (Frequency Division Multiple Access en anglais) combiné avec une répartition temporelle (Time Division Multiple Access en anglais). Le média de transmission peut être de différentes natures. Par exemple, il peut s'agir d'une transmission par câble, par voie hertzienne, ou par satellite...

Dans un système d'accès à répartition fréquentielle, une fréquence porteuse est attribuée à chaque terminal pour transmettre des données vers la station de tête. Les terminaux étant équipés d'oscillateurs locaux imprécis, la fréquence porteuse effectivement utilisée par un terminal présente une erreur qui peut être relativement importante avec la fréquence porteuse qui aurait dû être utilisée en théorie.

Lorsque la répartition fréquentielle est combinée à une répartition temporelle, des terminaux différents peuvent transmettre des données dans des intervalles de temps consécutifs en utilisant des fréquences porteuses différentes, avec des erreurs en fréquence différentes par rapport aux fréquences théoriques qui auraient dues être utilisées. La station de tête dispose donc de peu de temps pour effectuer les traitements relatifs à la fréquence porteuse des signaux reçus.

L'invention présente notamment l'avantage de permettre d'estimer et de corriger très rapidement l'écart en fréquence entre le signal reçu et la porteuse théorique. En particulier cette estimation et cette correction peuvent se faire pour chaque nouveau paquet reçu en provenance de l'un quelconque des terminaux du système de transmission.

Sur la figure 2 on a représenté un schéma général d'un récepteur 10 selon l'invention. Le récepteur 10 comporte un oscillateur local 12 et un mélangeur 13 pour transposer le signal reçu 14 de telle sorte que le spectre du signal transposé soit théoriquement centré sur une fréquence F' proche de zéro. Le signal transposé est filtré par un filtre de réjection 16 pour éliminer les fréquences images autour de 2Fp (où Fp est la fréquence porteuse théorique du signal reçu). Le signal obtenu en sortie du filtre 16 est échantillonné par un dispositif de sur - échantillonnage 18 qui prélève N échantillons pour chaque symbole du signal transposé. Les échantillons prélevés sont stockés dans une mémoire 20,puis appliqués à un filtre passe bande 22. Des moyens 25 de recherche de l'instant d'échantillonnage optimal sélectionnent un échantillon pour N échantillons disponibles en sortie du filtre passe bande 22. Les échantillons délivrés par les moyens de recherche 25 sont stockés dans une mémoire 26 d'une part, et transmis à un estimateur de fréquence 27 d'autre part. L'estimateur en fréquence 27 estime l'erreur en fréquence $\Delta f(i)$ relative au signal stocké. En fonction de la valeur de cette erreur $\Delta f(i)$, une information de correction 28 est transmise par un commutateur 29, soit à des moyens de centrage 30, soit à des moyens 32 de correction du signal stocké dans la mémoire 26. Les moyens de centrage 30 ont pour fonction de centrer en fréquence le filtre passe bande 22 et le signal stocké dans la mémoire 20 à partir de l'erreur en fréquence estimée. Les moyens de correction 32 ont pour fonction de corriger l'erreur en fréquence relative au signal stocké dans la mémoire 26.

Dans ce mode de réalisation, le signal reçu est préalablement transposé autour d'une fréquence P proche de zéro. De façon avantageuse, on choisit F'=0, ce qui revient à transposer le signal en bande de base. Toutefois, si la fréquence du signal reçu est suffisamment faible, la transposition peut être unitaire, ce qui revient à supprimer l'opération de transposition, le signal transposé étant alors identique au signal reçu.

L'estimateur de fréquence 27 est constitué par un estimateur connu, par exemple par l'un des estimateurs décrits dans l'article "Feedforward Estimation for PSK: a tutorial review" de Michele Morelli et Umberto Mengali publié dans la revue European Transactions on Telecommunications, volume 9, n°2, mars - avril 1998.

En centrant le signal reçu (éventuellement après transposition) et le filtre passe bande, l'invention permet d'éviter qu'une partie du signal utile ne soit coupée par le filtre passe bande à la réception. Elle permet donc de limiter les interférences inter-symboles en sortie du filtre passe bande.

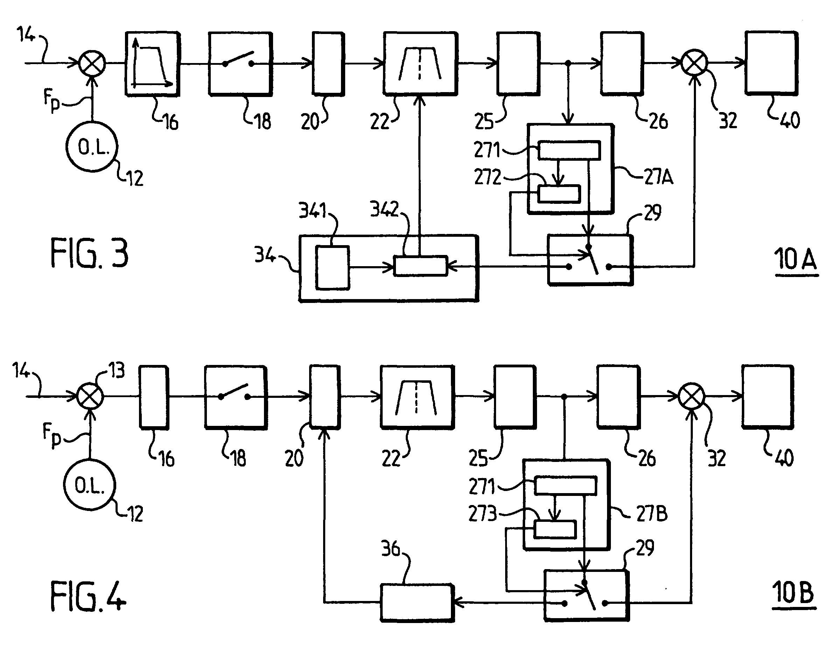

Dans les modes de réalisation qui vont maintenant être décrits en référence aux figures 3 à 5 le signal reçu est transposé en bande de base.

Sur la figure 3, on a représenté un premier mode de réalisation 10A d'un récepteur selon la figure 2. Dans ce mode de réalisation, les moyens de centrage sont constitués par des moyens 34 de décalage des coefficients initiaux du filtre 22. Les moyens de décalage 34 procèdent par itérations successives, jusqu'à ce que la différence $\Psi(i)$ entre deux estimations successives $\Delta f(i-1)$ et $\Delta f(i)$ de l'erreur en fréquence soit inférieure à un seuil S1 fixé (avec $\Delta f(0)=0$). Le nombre total d'itérations est noté n.

Le signal reçu étant d'abord transposé en bande de base, le filtre passe bande 22 est initialement centré sur zéro. L'estimateur de fréquence 27A comporte un estimateur de fréquence proprement dit 271, qui estime l'erreur en fréquence $\Delta f(i)$ relative au signal stocké pour une certaine position du filtre 22. La différence $\Psi(i)=\Delta f(i)-\Delta f(i-1)$ entre deux estimations successives de l'erreur en fréquence est comparée au seuil S1 par un circuit de comparaison 272. Le résultat de cette comparaison est utilisé pour commander le commutateur 29. Lorsque la différence $\Psi(i)$ est supérieure au seuil S1, l'erreur en fréquence $\Delta f(i)$ est transmise aux moyens de décalage 34. Lorsque la différence $\Psi(i)$ est inférieure ou égale à S1, l'erreur en fréquence $\Delta f(i)$ est transmise aux moyens de correction 32. Les moyens de décalage 34 sont constitués par une mémoire 341 qui contient les coefficients initiaux du filtre 22, et par des moyens de multiplication 342. Les moyens de multiplication 342 multiplient les coefficients stockés dans la mémoire 341 par l'exponentielle $e^{-2\pi j.\Delta f(i).t}$ où t indique le temps échantillonné (c'est-à-dire que t=k/B où k est l'indice de l'échantillon dans la mémoire 20 et B est la fréquence symbole), et $\Delta f(i)$ est l'erreur en fréquence estimée lors de la $i^{ème}$ itération. Dans ce mode de réalisation 10A, le signal stocké dans la mémoire 26 n'est pas en bande de base. Les moyens de correction 32 ont pour fonction de transposer le signal finalement obtenu on sortie du filtre 22 de façon à le ramener en bande de base. Pour cela le signal contenu dans la mémoire 26 est multiplié par l'exponentielle $e^{-2\pi j.\Delta f(n).t}$ où $\Delta f(n)$ est l'erreur en fréquence obtenue lors de la dernière itération, et t est le temps échantillonné.

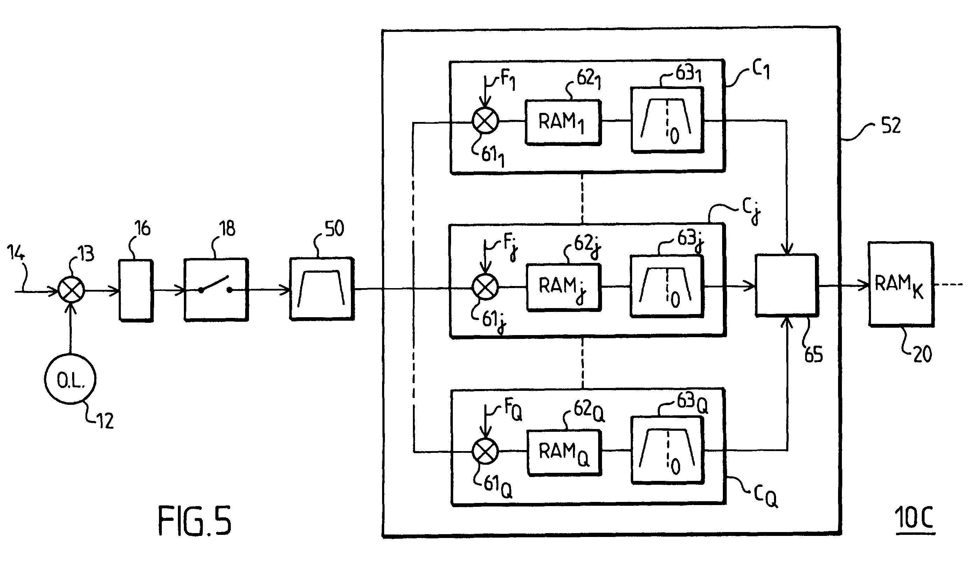

Sur les figures 4 et 5 on a représenté deux variantes 10B et 10C d'un mode de réalisation préférentiel de l'invention. Dans ce mode de réalisation préférentiel, les moyens de centrage sont constitués par des moyens de décalage 36 du signal stocké dans la mémoire 20. Ces moyens de décalage 36 procèdent par itérations successives jusqu'à ce que l'erreur on fréquence $\Delta f(i)$ estimé atteigne une valeur inférieure à un seuil fixé S2.

Comme indiqué sur la figure 4, l'estimateur 27B comporte alors un estimateur de fréquence proprement dit 271 qui estime le décalage en fréquence $\Delta f(i)$ relatif au signal stocké dans la mémoire 20, et un circuit de comparaison 273, qui compare l'estimation obtenue $\Delta f(i)$ à un seuil S2. Comme dans le mode de réalisation de la figure 3, le résultat de cette comparaison est utilisé pour commander le commutateur 29. Lorsque l'estimation $\Delta f(i)$ est supérieure à S2, elle est transmise par le commutateur 29 aux moyens de décalage 36. Lorsqu'elle est inférieure ou égale à S2, elle est transmise aux moyens de correction 32. Les moyens de décalage 36 multiplient les échantillons du signal stockés dans la mémoire 20 par l'exponentielle $e^{-2\pi j.\Delta f(i).t}$ pour corriger l'erreur en fréquence $\Delta f(i)$. Et les moyens de correction 32 multiplient les échantillons du signal stockés dans la mémoire 26 par $e^{-2\pi j.\Delta f(n).t}$ pour corriger l'erreur résiduelle $\Delta f(n)$ qui a été estimée lors de la dernière itération.

Sur la figure 5 on a représenté une seconde variante 10C du mode de réalisation préférentiel de l'invention. En plus des éléments du récepteur 10B décrit en référence à la figure 4, ce récepteur 10C comporte, entre la sortie du dispositif de sur-échantillonnage 18 et l'entrée de la mémoire 20, un filtre à large bande 50 destiné à capturer les signaux dans une bande élargie par rapport à celle du filtre passe bande 22. Le filtre à large bande 50 est connecté à des moyens de traitement 52 dont la fonction est de transposer le signal capturé dans une bande étroite autour de zéro. Ces moyens de traitement 52 comportent Q chaînes de traitement parallèles identiques $C_j$ (j=1, ...Q) . Chaque chaîne de traitement $C_j$ comporte un dispositif de décalage $61_j$ pour décaler le signal capturé d'une fréquence $F_j$, une mémoire $62_j$ pour stocker le signal décalé de la fréquence $F_j$, et un filtre à bande étroite $63_j$ pour filtrer autour de zéro le signal stocké dans la mémoire $62_j$. Des moyens 65 comparent les puissances des Q signaux délivrés en sortie des Q filtres à bande étroite $63_j$ et sélectionnent le signal de puissance maximum (j=K). C'est ce signal de puissance maximum qui est stocké dans la mémoire 20.

Cette seconde variante consiste à capturer les signaux dans une bande de fréquence plus large que celle du filtre passe bande et à analyser le spectre du signal capturé par sous-bandes pour sélectionner la sous-bande qui contient le signal reçu (la sous-bande K dans l'exemple de la figure 5). Cette analyse consiste notamment à décaler le signal reçu de façon à le placer dans la bande du filtre passe bande (décalage d'une fréquence $F_K$). Ce signal décalé est stocké dans la mémoire $62_K$. Il est ensuite recopié dans la mémoire 20 pour être traité comme cela a été expliqué en référence à la figure 4. La largeur des sous-bandes doit être inférieure à celle de la plage d'acquisition de l'estimateur de fréquence 27 pour garantir la capture du signal.

Cette seconde variante permet de gérer des écarts de fréquence qui se situent hors de la plage d'acquisition de l'algorithme d'estimation utilisé.

Dans la pratique, pour une fréquence porteuse de 30GHz et un oscillateur local dont la précision est égale à 1ppm, le mode de réalisation de la figure 4 permet de recevoir correctement des signaux présentant une erreur en fréquence normalisée $\tilde{\Delta f}$ de ±40%. En revanche, si l'oscillateur local a une précision de 10ppm, pour recevoir correctement un signal qui présente une erreur en fréquence normalisée $\tilde{\Delta f}$ de ±40%, il faut utiliser le mode de réalisation de la figure 5 avec un filtre large bande dont la bande totale correspond à sept sous-bandes (Q=7).

De façon avantageuse, lorsque l'estimateur 27 procède par itérations successives, on utilise des estimateurs différents au fur et à mesure des itérations. En effet comme il ressort de l'article de Michele Morelli et Umberto Mengali, les estimateurs sont caractérisés par différents paramètres, notamment par la précision de l'estimation obtenue, la largeur de la plage d'acquisition de l'écart en fréquence, le niveau minimum du rapport signal à bruit du signal traité, la complexité de l'algorithme. Certains de ces paramètres ont des évolutions opposées. En particulier la précision de l'estimation est d'autant plus faible que la plage d'acquisition est large; et les estimateurs sont d'autant plus complexes qu'ils sont capables de fonctionner avec des rapports signal à bruit plus faibles. On utilise donc par exemple des estimateurs peu complexes et qui ont une grande plage d'acquisition pour la ou les premières itérations, puis on utilise des estimateurs plus complexes et plus précis.

Sur la figure 5 on a représenté les différentes étapes d'un procédé préférentiel de correction en fréquence à la réception selon l'invention. Ce procédé comporte dans l'ordre les étapes suivantes:

- étape 70: conversion du signal reçu en bande de base,
- étape 71: sur-échantillonnage du signal en bande de base,
- étape 72: filtrage à large bande du signal en bande de base, pour capturer un signal reçu dans une bande plus large que celle du filtre passe bande 22.
- étape 73: traitement du signal capturé pour le transposer dans une bande étroite autour de zéro. Ce traitement consiste en Q sous-traitements similaires consistant chacun à décaler le signal capturé d'une fréquence $F_j$ (j=1,...,Q), à stocker le signal décalé de la fréquence $F_j$, à filtrer les signaux décalés en utilisant des filtres à bande étroite centrés sur zéro, à comparer les puissances P(j) des Q signaux filtrés pour sélectionner celui qui a la plus grande puissance P(k),
- étape 74: stockage du signal sélectionné à l'étape 73.
- étape 75: filtrage autour de zéro et sous-échantillonnage.
- étape 76: stockage du signal filtré.
- étape 77: estimation de l'erreur en fréquence Δf(i) relative au signal stocké à rétape 74.
- étape 78: test de la valeur de l'écart obtenu: si Δf(i)>S2 le fonctionnement se poursuit à rétape 79; sinon il se poursuit à l'étape 80.
- étape 79: décalage du signal mémorisé à l'étape 74 pour corriger l'écart de fréquence Δf(i) estimé à l'étape 77. Reprise du fonctionnement à rétape 74.
- étape 80: correction en fréquence du signal stocké à rétape 76. Délivrance d'un signal corrigé en fréquence.

A titre d'exemple les seuils S1 et S2 sont fixés à 0,1% de la fréquence symbole (B).

Il suffit de supprimer les étapes 72 et 73 pour obtenir un procédé de correction en fréquence à la réception conforme à la première variante 10B du mode de réalisation préférentiel de l'invention.

Il est bien évident que les moyens 50, 52 et 65 décrits sur la figure 5 pour capturer les signaux dans une bande de fréquence plus large que celle du filtre passe bande 22 peuvent également être ajoutés dans le récepteur de la figure 3, en amont de la mémoire 20.

Il est important de noter que l'invention n'implique pas la transmission d'un signal pilote entre l'émetteur et le récepteur et qu'elle s'applique donc à des systèmes de transmission dans lesquels la transmission d'un tel signal pilote n'est pas prévue ou n'est pas possible. Par ailleurs, l'invention est utilisable en combinaison avec des mécanismes de compensation à l'émission à partir de l'estimation faite par le récepteur.

**Revendications**

**1.** Système de transmission par paquets, d'au moins un terminal (2) vers une station de tête (1), ladite station de tête (1) comportant des moyens de réception pour recevoir un signal transmis par un terminal et un estimateur de fréquence (27) pour estimer à partir du signal reçu (14) une erreur en fréquence (Δf) relative audit terminal, caractérisé en ce que lesdits moyens de réception comportent un filtre passe bande (22) et des moyens de centrage (30) pour centrer en fréquence l'un par rapport à l'autre, le filtre passe bande et le signal stocké, en fonction de ladite erreur en fréquence.

**2.** Système de transmission par paquets selon la revendication 1, caractérisé en ce que lesdits moyens de centrage (30) sont constitués par des moyens de décalage en fréquence du signal reçu.

**3.** Système de transmission par paquets selon la revendication 1, caractérisé en ce que lesdits moyens de centrage procèdent par itérations successives.

**4.** Système de transmission par paquets selon la revendication 1, caractérisé en ce que lesdits moyens de réception comportent, en amont du filtre passe bande (22), un filtre à large bande (50) et des moyens de traitement (52) pour transposer un signal capturé par le filtre à large bande dans la bande dudit filtre passe bande.

**5.** Récepteur pour système de transmission par paquets, comportant des moyens de réception pour recevoir un signal transmis par un terminal, et un estimateur de fréquence (27) pour estimer à partir du signal reçu une erreur en fréquence (Δf) relative audit terminal, caractérisé en ce que lesdits moyens de réception comportent un filtre passe bande (22) et des moyens de centrage (30) pour centrer en fréquence, l'un part rapport à l'autre, le filtre passe bande et le signal stocké, en fonction de ladite erreur en fréquence (Δf).

**6.** Récepteur selon la revendication 5, caractérisé en ce qu'il comporte, en amont du filtre passe bande (22), un filtre à large bande (50) et des moyens de traitement (52) pour transposer un signal capturé par le filtre à large bande dans la bande dudit filtre passe bande.

**7.** Récepteur selon la revendication 5, caractérisé en ce que lesdits moyens de centrage (30) procèdent par itérations successives.

**8.** Procédé de correction en fréquence à la réception pour système de transmission par paquets, ledit procédé comportant:

- une étape de réception pour recevoir un signal dit signal reçu,
- une étape d'estimation de fréquence pour estimer une erreur en fréquence relative au signal reçu,

  caractérisé en ce qu'il comporte:
- une étape (75) de filtrage passe bande, pour filtrer le signal reçu au moyen d'un filtre passe bande (22),
- une étape de centrage (79) pour centrer en fréquence, l'un par rapport à l'autre, le filtre passe bande et le signal reçu, en fonction de ladite erreur en fréquence.

**9.** Procédé de correction de fréquence selon la revendication 8, caractérisé en ce qu'il comporte, en amont de ladite étape de filtrage passe bande, une étape de filtrage à large bande (72) pour capturer un signal dans une large bande de fréquence, et une étape de traitement (73) pour transposer le signal capturé dans une bande étroite dans la bande dudit filtre passe bande (22).

**10.** Procédé de correction de fréquence selon la revendication 8, caractérisé an ce que ladite étape de centrage est répétée plusieurs fois.

FIG.1
1
2
2
2
3
FIG.2
14
13
12
O.L.
Fp - F'
16
18
20
22
F'
25
26
27
28
29
30
32
40
10

14
Fp
O.L.
12
16
18
20
22
25
26
27A
271
272
29
32
40
10A
341
342
34
14
Fp
O.L.
12
13
16
18
20
22
25
26
27B
271
273
29
32
40
36
10B

FIG. 3

FIG. 4

52
RAMK
20
10C
65
C1
Cj
CQ
631
63j
63Q
621
62j
62Q
RAM1
RAMj
RAMQ
F1
Fj
FQ
611
61j
61Q
50
18
16
13
14
O.L.
12

FIG.5

O.L.
70
71
72
k
73
RAM
74
75
0
RAM
76
Δf(i)
77
Δf(i)>S2?
78
Δf(i)>S2
Δf(i)≤S2
xe-2πj Δf(i).t
79
xe-2πj Δf(i).t
80

FIG.6

Office européen
des brevets

# RAPPORT DE RECHERCHE EUROPEENNE

Numéro de la demande
EP 00 20 1145

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 863 623 A (NIPPON ELECTRIC CO)<br>9 septembre 1998 (1998-09-09)<br>* abrégé *<br>* page 3, ligne 7 - ligne 55 *<br>* page 4, ligne 30 - ligne 41 *<br>* figure 2 * | 1-10 | H03J3/08<br>H03J7/04<br>H04L27/233 |
| D,A | US 5 794 119 A (EVANS ALLAN ET AL)<br>11 août 1998 (1998-08-11)<br>* abrégé *<br>* revendication 1 * | 1-10 | |
| A | WO 97 07618 A (PACIFIC COMM SCIENCES INC)<br>27 février 1997 (1997-02-27)<br>* abrégé *<br>* page 5, ligne 3 - ligne 13 *<br>* figure 2 * | 1-10 | |
| A | EP 0 701 320 A (NIPPON ELECTRIC CO)<br>13 mars 1996 (1996-03-13)<br>* abrégé *<br>* page 4, ligne 5 - ligne 18 *<br>* figure 3 * | 1-10 | **DOMAINES TECHNIQUES RECHERCHES (Int.Cl.7)**<br>H03J<br>H04L |

Le présent rapport a été établi pour toutes les revendications

| Lieu de la recherche | Date d'achèvement de la recherche | Examinateur |
|---|---|---|
| LA HAYE | 4 juillet 2000 | Toumpoulidis, T |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 00 20 1145

La présente annexe indique les membres de la famille de brevets relatifs aux documents brevets cités dans le rapport de recherche européenne visé ci-dessus.
Lesdits members sont contenus au fichier informatique de l'Officeeuropéen des brevets à la date du
Les renseignements fournis sont donnés à titre indicatif et n'engagent pas la responsabilité de l'Office européen des brevets.

04-07-2000

| Document brevet cité au rapport de recherche | Date de publication | Membre(s) de la famille de brevet(s) | Date de publication |
|---|---|---|---|
| EP 0863623 A | 09-09-1998 | JP 10247858 A | 14-09-1998 |
| | | CN 1203485 A | 30-12-1998 |
| US 5794119 A | 11-08-1998 | AU 716711 B | 02-03-2000 |
| | | AU 1741997 A | 11-06-1997 |
| | | BR 9611821 A | 13-07-1999 |
| | | CA 2237465 A | 29-05-1997 |
| | | CN 1203003 A | 23-12-1998 |
| | | EP 0862834 A | 09-09-1998 |
| | | WO 9719557 A | 29-05-1997 |
| WO 9707618 A | 27-02-1997 | US 5757864 A | 26-05-1998 |
| | | AU 6604896 A | 12-03-1997 |
| | | EP 0883951 A | 16-12-1998 |
| | | JP 11511311 T | 28-09-1999 |
| EP 0701320 A | 13-03-1996 | JP 2751840 B | 18-05-1998 |
| | | JP 8084083 A | 26-03-1996 |
| | | DE 69516779 D | 15-06-2000 |
| | | US 5974098 A | 26-10-1999 |

EPO FORM P0460

Pour tout renseignement concernant cette annexe : voir Journal Officiel de l'Office européen des brevets, No.12/82